# EUROPÄISCHE PATENTSCHRIFT

(11) **EP 2 198 387 B1**
(45) Veröffentlichungstag und Bekanntmachung des Hinweises auf die Patenterteilung: **23.12.2015**
(21) Anmeldenummer: 08838440.9
(22) Anmeldetag: 01.10.2008
(51) Int. Cl.: G06K 7/00

(54) **PRÜFGERÄT FÜR RFID-SYSTEME SOWIE RFID-ANORDNUNGEN UND VERFAHREN ZUM BETREIBEN EINES PRÜFGERÄTS IN EINEM RFID-SYSTEM**
TEST DEVICE FOR RFID SYSTEMS AND RFID ARRANGEMENTS AND METHOD FOR OPERATING A TEST DEVICE IN AN RFID SYSTEM
APPAREIL DE CONTRÔLE POUR SYSTÈMES RFID AINSI QUE DISPOSITIFS RFID ET PROCÉDÉ DE FONCTIONNEMENT D'UN APPAREIL DE CONTRÔLE DANS UN SYSTÈME RFID

(30) Priorität: 05.10.2007 DE 102007047768
(43) Veröffentlichungstag der Anmeldung: 23.06.2010
(73) Patentinhaber: CISC Semiconductor GmbH, 9020 Klagenfurt (AT)
(72) Erfinder: PREISHUBER-PFLUEGL, Josef, A-9020 Klagenfurt (AT); PISTAUER, Markus, A-9073 Viktring (AT)
(74) Vertreter: Epping - Hermann - Fischer
(86) Internationale Anmeldenummer: PCT/EP2008/063173
(87) Internationale Veröffentlichungsnummer: WO 2009/047190

(56) Entgegenhaltungen:
- EP-A1- 1 141 879
- WO-A-2007/085705
- US-A1- 2007 001 851

## Beschreibung

Die Erfindung betrifft ein Prüfgerät für RFID-Systeme gemäß dem Oberbegriff des Patentanspruchs 1, sowie ein Verfahren zum Betreiben eines solchen Prüfgeräts in einem RFID-System.

RFID-Systeme arbeiten mit so genannten Datenträgern, auch Tag oder Transponder genannt, die sich in der Regel an einem Gegenstand befinden und diesen kennzeichnen. Dazu ist entsprechendes Lesegerät vorgesehen, welches oft als Lese-/Schreibgerät bezeichnet wird, und das zumindest eine Kennung des Datenträgers auslesen kann. Die Kommunikation zwischen Datenträger und Lesegerät erfolgt kontaktlos. RFID-Systeme werden dazu eingesetzt, Gegenstände automatisch zu identifizieren. Eine Einsatzmöglichkeit ist die Ortung von Akten in einem Büro, wobei jede Akte mit einem Transponder versehen ist. Wenn nun am Zugang zu jedem Raum ein Lesegerät installiest ist, so können die Akten beim Hinein- und Heraustragen identifiziert werden, so dass der aktuelle Standort der Akte jederzeit bekannt ist. Eine andere Einsatzmöglichkeit ist die Kontrolle von Warenbewegungen in einem Lager oder einer Produktionsstätte.

Für derartige Einsatzbeispiele ist es wichtig, dass Datenträger sicher erkannt werden. Insbesondere bei schwierigen räumlichen Bedingungen oder Störfeldern muss sichergestellt sein, dass Datenträger nicht ein Lesegerät passieren können, ohne dabei erkannt zu werden.

Die Funktionsweise eines RFID-Systems besteht darin, dass das Lesegerät ein elektromagnetisches Lesefeld aufbaut. Wenn nun ein Datenträger in das Lesefeld eines Lesegerätes gelangt, kommt es zu einer Wechselwirkung zwischen Lesegerät und Transponder.

Bei so genannten ID-Tags wird dem Lesefeld in kennzeichnender Weise Energie entzogen, was auf Seiten des Lesegerätes messbar ist. Da jeder ID-Tag eine individuelle Charakteristik entsprechend einer Identifikationsnummer besitzt, kann auf Seiten des Lesegerätes erkannt werden, welche Identifikationsnummer ein Transponder besitzt.

Oft als Chipkarten bezeichnete Datenträger besitzen einen Chip, der vom Lesegerät empfangene Daten verarbeiten und dem Lesegerät antworten kann. Die Stromversorgung dieser kontaktlos arbeitenden Datenträger erfolgt oftmals ebenfalls durch die Energie des Lesefeldes, die nach dem Prinzip eines Transformators dem Lesefeld entzogen wird. Eine derartige Art der Energieversorgung ist bei induktiver Kopplung möglich, die bis zu einer Distanz zwischen Lesegerät und Datenträger von wenigen Metern, typischerweise einem Meter eingesetzt wird. Daneben gibt es auch Datenträger, die mit kapazitiver Kopplung arbeiten oder im Fernfeld arbeiten, wobei sie Daten über elektromagnetische Wellen austauschen.

Bei dem Aufbau eines RFID-Systems in einem Büro oder einer Produktionsanlage muss die Anordnung und Auslegung der Lesegeräte auf die Räumlichkeiten abgestimmt sein, damit das Lesefeld in ausreichender Stärke zur Verfügung steht und so eine einwandfreie Erkennung der Datenträger ermöglichen kann. Gleichzeitig dürfen aber Grenzwerte bezüglich der Stärke des Lesefeldes nicht überschritten werden, um gesetzlichen Vorgaben zu genügen und andere elektronische Geräte, die in der Nähe der Lesegeräte installiert sind, nicht zu stören. Zusätzliche Schwierigkeiten bereiten Toleranzen der Datenträger bezüglich zeitlichem Signalverlauf, Amplitude oder Phase.

Es ist möglich, nach der Installation eines Lesegerätes mit Prüfgeräten, die eine Antenne und eine Steuereinrichtung aufweisen, das Lesefeld zu vermessen, um so festzustellen, ob die Voraussetzungen für einen ordnungsgemäßen Betrieb gegeben sind. Dennoch kommt es immer wieder zum Ausfall von RFID-Systemen, was oftmals mit erheblichen Behinderungen des Büro- oder Produktionsbetriebes verbunden ist.

Aus der WO 2007/085705 A1 ist ein System zur Analyse von RFID-Systemen bekannt, welches sowohl Signale von Datenträgern und Lesegeräten erfassen und analysieren, als auch selber ein elektromagnetisches Feld erzeugen kann.

Die US 2007/0001851 A1 offenbart ein konfigurierbares RFID-System, bei dem mehrere simulierte Tags mit einem Reader getestet werden.

Es ist Aufgabe der Erfindung, ein Prüfgerät anzugeben, mit welchem Fehler, die später zu einem Ausfall führen könnten, frühzeitig erkannt werden können oder im Fall eines Ausfalls diesen anzeigen.

Diese Aufgabe wird durch ein Prüfgerät gemäß Patentanspruch 1 gelöst.

Die Erfindung umfasst die Erkenntnis, dass es für die Emulation eines passiven Datenträgers nicht genügt, die entsprechenden Protokolle in einem Prüfgerät umzusetzen. Bei realen passiven Datenträgern bewirkt die Datenverarbeitung in einer schreibenden, aber auch in einer lesenden Betriebsart Rückwirkung auf das Lesefeld. Eine aktive Messtechnik, wie sie in Prüfgeräten eingesetzt wird, hat dagegen keine Rückwirkung auf das System. Denn solche Geräte besitzen eine eigene Energieversorgung und sind nicht darauf angewiesen, Energie aus dem Lesefeld zu beziehen. Die nach der Erfindung vorgesehene Vorrichtung zur Belastung des Lesefeldes ermöglicht eine Nachbildung der Rückwirkung eines passiven Datenträgers auf das Lesefeld.

Bei dem erfindungsgemäßen Prüfgerät ist von Vorteil, dass die aktive Energieversorgung im Vergleich zu passiven Datenträgern eine wesentlich höhere Empfindlichkeit in der Signalerkennung als auch Signalrückgabe ermöglicht. Dies ist insbesondere wichtig, wenn gleichzeitig der Datenverkehr mit anderen passiven Datenträgern im Lesefeld überwacht werden soll oder die Grenzen des RFID-Systems bei fehlerhaften Datenträgern ausgetestet werden sollen. Dabei ist das erfindungsgemäße Prüfgerät einfach aufgebaut.

Das erfindungsgemäße Prüfgerät kann als Teil des RFID-Systems installiert werden und ermöglicht dadurch eine laufende Überwachung des Betriebs des RFID-Systems.

In einer günstigen Ausgestaltung des Prüfgeräts erfolgt die Belastung des Lesefelds dadurch, dass aus der Feldenergie eine Versorgungsspannung erzeugt wird, die entweder Teile der Funktionseinheiten des Prüfgerät oder eine separate Last versorgen. Im ersten Fall könnten die versorgten Funktionseinheiten den tatsächlich in Datenträgern eingesetzten Funktionseinheiten entsprechen. Im zweiten Fall kann als Last ein einfacher Widerstand eingesetzt werden oder aber eine steuerbare Last, über die auch ein bestimmtes Lastprofil realisiert werden kann. So können kurzzeitige Lastschwankungen nachgebildet werden.

In vorteilhaften Ausbildungen der Erfindung ist vorgesehen, die Signalstärke des Lesefeldes und/oder den Datenfluss zwischen Lesegerät und Datenträger zu überwachen. Abweichungen in der Signalstärke, Ausfall von einzelnen Antennen des RFID-Systems oder Verzögerungen beim Lesen von Daten können so erkannt werden, bevor es zu einem Ausfall des RFID-Systems beziehungsweise einer erheblichen Beeinträchtigung des Betriebs des RFID-Systems kommt. Fehler können anschließend bearbeitet und behoben werden, wobei die Fehlerbehebungen zeitlich so gelegt werden können, dass es nicht zu einer Beeinträchtigung des Arbeitsablaufs kommt. Ein Prüfung nach der Erfindung ist insbesondere von Bedeutung, da nach dem Stand der Technik das Nicht-Erkennen von Datenträgern dem RFID System nicht bekannt wird und Information bzgl. einer erforderlichen Fehlerbehebung die Gesamtsystemsicherheit erheblich erhöht.

In einer vorteilhaften Ausgestaltung der Erfindung werden Messungen fortlaufend durchgeführt und Messergebnisse vorzugsweise mit einer Zeitinformation über den Messzeitpunkt protokolliert. Wenn es zum Auftreten eines Fehlers kommt, kann das Protokoll aus der Zeit vor dem Fehler ausgewertet werden, was eine Fehlerdiagnose erheblich vereinfacht.

Wenn auch Messergebnisse vorzugsweise fortlaufend protokolliert werden, genügt es in der Regel, wenn eine Auswertung in größeren Zeitabständen vorgenommen wird, beispielsweise einmal täglich. Da sich Ausfälle normalerweise durch veränderte Messergebnisse ankündigen, kann so eine Früherkennung vorgenommen werden bzw. im Fehlerfall Information zu dessen Reproduktion herangezogen werden.

In einer bevorzugten Ausgestaltung eines erfindungsgemäßen Prüfgerätes weist dieses einen Demodulator auf, so dass der Datenverkehr zwischen einem Schreib-/Lesegerät und einem im Umfeld befindlichen Datenträger mitgelesen und analysiert werden kann.

In einer vorteilhaften Ausgestaltung eines erfindungsgemäßen Prüfgeräts ist die Steuereinrichtung des Prüfgerätes dazu eingerichtet, Daten zu bewerten und zu selektieren und nur die selektierten Daten an der Kommunikationsschnittstelle zur weiteren Verarbeitung bereit zu stellen. Dadurch wird der Datenverkehr reduziert und ein Schreib-/Lesegerät, welches zur Auswertung der Messergebnisse eingerichtet sein könnte, nicht unnötig belastet.

Die Auswertung der Messergebnisse kann bereits in dem Prüfgerät erfolgen, sie könnte aber auch in dem Schreib-/Lesegerät oder in einem zusätzlichen Kontrollgerät vorgenommen werden. Insbesondere bei Auswertung durch das Prüfgerät werden vorzugsweise Daten vom Lesegerät zu dem Prüfgerät übermittelt, damit das Prüfgerät über alle zur Durchführung einer Auswertung erforderlichen Daten verfügt.

In einer günstigen Ausgestaltung eines erfindungsgemäßen Prüfgerätes ist dieses dazu eingerichtet, einen Datenträger im Lesefeld zu emulieren. Dadurch ist ein einfacher Funktionstest durchführbar, wenn nämlich geprüft wird, ob das Lesegerät eine durch das Prüfgerät emulierte ID-Funktion erkennen kann.

Durch eine vorzugsweise feste Anordnung des Prüfgerätes in dem RFID-System ist eine Reproduzierbarkeit der Messungen gegeben, so dass Veränderungen zuverlässig feststellbar sind.

Eine erfindungsgemäße RFID-Anordnung weist mindestens ein Lesegerät mit mindestens einer Antenne zur Erzeugung eines Lesefeldes für Datenträger auf sowie ein Prüfgerät, wie es oben genannt worden ist.

Ein erfindungsgemäßes Verfahren ist in Anspruch 10 angegeben.

Weitere vorteilhafte Ausgestaltungen erfindungsgemäßer Prüfgeräte sind in den Unteransprüchen angegeben.

Die Erfindung wird nachfolgend anhand von Ausführungsbeispielen näher erläutert. Es zeigt:
Figur 1 eine RFID-Anordnung mit einem Lesegerät und einem erfindungsgemäßen Prüfgerät,
Figur 2 ein zweites Ausführungsbeispiel einer erfindungsgemäßen RFID-Anordnung,
Figur 3 ein Blockschaltbild eines Ausführungsbeispiels eines erfindungsgemäßen Prüfgeräts mit seinen Datenverarbeitungskomponenten,
Figur 4 ein Blockschaltbild eines Ausführungsbeispiels eines erfindungsgemäßen Prüfgeräts mit Stromversorgungskomponenten,
Figur 5 ein Blockschaltbild eines weiteren Ausführungsbeispiels eines erfindungsgemäßen Prüfgeräts,
Figur 6 ein drittes Ausführungsbeispiel einer erfindungsgemäßen RFID-Anordnung und
Figur 7 ein Ablaufdiagramm des Betrieb eines Prüfgeräts nach der Erfindung.

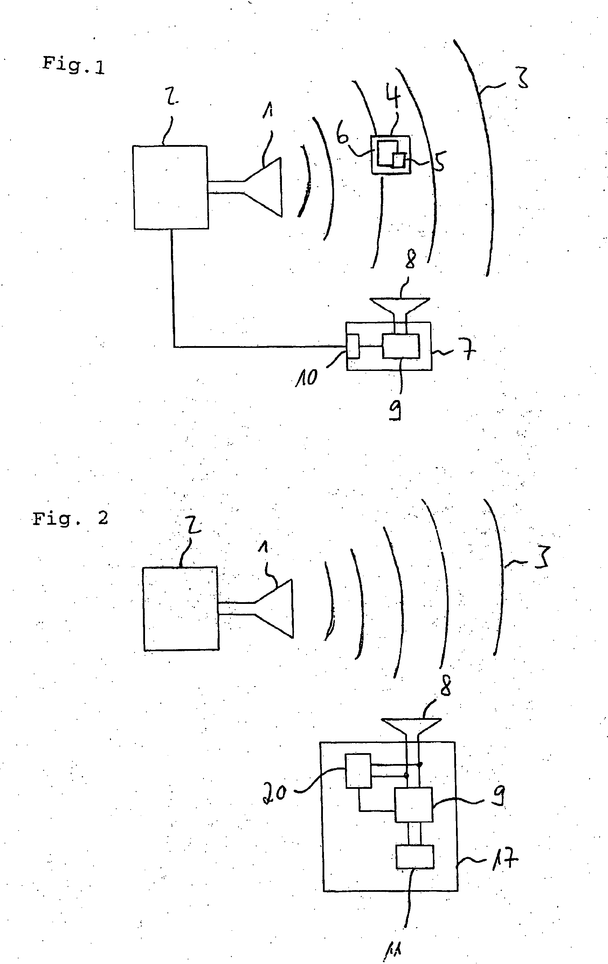

Die Figur 1 zeigt den grundsätzlichen Aufbau eines RFID-Systems mit einem erfindungsgemäßen Prüfgerät. Die Abkürzung RFID bedeutet "Radio Frequency Identification" (Identifizierung über Radiowellen). In der einfachsten Ausführung besteht ein RFID-System aus einem Lesegerät 2 mit einer Antenne 1, die mit dem Lesegerät 2 verbunden ist. Das Lesegerät 2 erzeugt über die Antenne 1 ein elektromagnetisches Lesefeld 3. Ein passiver Datenträger 4, der sich im Lesefeld 3 befindet, kann über das elektromagnetische Feld mit dem Lesegerät 2 kommunizieren. Man könnte natürlich auch Datenträger mit einer eigenen Energieversorgung einsetzen.

Im dargestellten Fall handelt es sich um einen passiven Datenträger, welcher einen Chip 5 sowie eine Antenne 6 aufweist. Über die Antenne 6 kann dem elektromagnetischen Feld 3 zum einen Energie entnommen werden, um den Chip 5 mit Strom zu versorgen, durch eine Modulation der dem Feld 3 entzogenen Energie kann darüber hinaus eine Datenübertragung zum Lesegerät 2 vorgenommen werden. Wenn das Lesegerät 2 Informationen zum Datenträger 4 übermitteln will, so erfolgt dies über eine Modulation bei der Erzeugung des Lesefeldes 3. Auf diese Weise ist beispielsweise ein Challenge/Response-Verfahren umsetzbar. Es ist ersichtlich, dass in einer solchen Betriebsart das Lesegerät als Schreib-/Lesegerät bezeichnet wird, da eine bidirektionale Datenübertragung erfolgt. Für die Beschreibung der erfindungsgemäßen Prüfgeräte wird der Begriff "Lesegerät" verwendet, ohne dass darunter eine Einschränkung oder ein Ausschluss von Schreib-/Lesegeräten zu verstehen ist.

In der dargestellten erfindungsgemäßen Anordnung ist mit dem Lesegerät 2 ein Prüfgerät 7 verbunden, wobei im Ausführungsbeispiel von Figur 1 die Verbindung über eine Leitung erfolgt die für Daten und/oder Energieübertragung zum/vom Prüfgerät verwendet werden kann. Die Verbindung zwischen Lesegerät und Prüfgerät kann auch über eine Steuereinheit für die beiden Geräte erfolgen.

In der Figur 2 ist ein Prüfgerät 17 mit einer Kommunikationsschnittstelle 20 zur kontaktlosen Kommunikation dargestellt. Die Energieversorgung des Prüfgerätes 17 erfolgt über ein Netzteil oder eine Batterie.

Das Prüfgerät 17 verfügt über eine Antenne 8 sowie eine Steuereinrichtung 9, die mit der Antenne verbunden ist. Außerdem ist die Steuereinrichtung 9 mit der Schnittstelle 20 verbunden, über welche eine Verbindung zum Lesergerät 2 hergestellt werden kann. Die Antenne 8 hat im Ausführungsbeispiel von Figur 2 eine Doppelfunktion. Einerseits erfolgt über sie die Messung von Feldern oder gesendeten Daten des Lesegerätes 2, anderseits wird sie zur Kommunikation zwischen dem Prüfgerät 17 und dem Lesegerät 2 eingesetzt. Um eine Störung des ordnungsgemäßen Betriebes zu vermeiden, kann für die Kommunikation zwischen dem Prüfgerät 17 und dem Lesegerät 2 eine andere Trägerfrequenz verwendet werden. Beispielsweise könnte das Lesefeld 3 zur Kommunikation mit einem Datenträger 4 mit einer Frequenz von 867 MHz betrieben werden, während die Kommunikation zwischen dem Prüfgerät 7 und Lesegerät 2 mit einer Trägerfrequenz von 2,45 GHz erfolgt. Eventuell müssen die Antennen 1 und 8 des Lesegeräts 2 bzw. des Prüfgeräts 17 an die Verwendung zweier Frequenzen angepasst werden.

Das Prüfgerät 17 misst Felddaten und überträgt die Messergebnisse über eine Kommunikationsschnittstelle 20. Diese ist wiederum mit der Antenne 8 gekoppelt, so dass die Daten über die Antenne 8 an das Lesegerät 2 übermittelt werden können. Zusätzlich ist in dem Prüfgerät 17 ein Speicher 11 vorgesehen, in dem die Messergebnisse gespeichert werden können. Dies ist insbesondere bei der kontaktlosen Ausgestaltung von Vorteil, wenn nämlich nicht zu jeder Zeit ein ausreichend starkes Lesefeld 3 zur Verfügung steht, beispielsweise weil sich mehrere andere Datenträger 4 im Lesefeld 3 befinden. Die Datenübertragung von Messergebnissen kann dann zu Zeiten erfolgen, wenn gerade kein anderer Datenträger im Feld 3 ist und insofern das Lesefeld ausschließlich für die Übertragung der Messergebnisse zur Verfügung steht..Insbesondere wird durch eine solche Vorgehensweise eine Störung des regulären Betriebs durch die Übertragung der Messergebnisse vermieden. Das Prüfgerät 17 misst ohnehin die Signalstärke des Lesefeldes 3, so dass es aufgrund der gemessenen Signalstärke erkennen kann, ob ein anderer Datenträger 4 im Feld vorhanden ist. Der Zeitpunkt, wann eine Datenübertragung günstig abgewickelt werden kann, ist so sehr einfach feststellbar.

Ein zeitverzögertes Übertragen von Messergebnissen zum Lesegerät 2 ist insbesondere dann unkritisch, wenn die Zeitpunkte, zu denen Messergebnisse aufgezeichnet werden, erfasst und mit abgespeichert werden. So lässt sich auch später eine exakte zeitlichen Zuordnung von bestimmten Ereignissen beim Lesegerät 2, im Feld 3 oder bei darin aufgenommen Datenträgern sowie beim Prüfgerät 17 vornehmen, so dass die Abläufe nachvollziehbar sind. Der Speicher 11 kann in größeren zeitlichen Abständen vom Lesegerät 2 oder einem zusätzlichen, nicht dargestellten Kontrollgerät ausgelesen werden, um Auswertungen durchzuführen.

Die vom Prüfgerät 17 durchzuführenden Messungen können vom Lesegerät 2 aus getriggert werden oder aber diese erfolgen in regelmäßigen zeitlichen Abständen, so dass zeitliche Abläufe erfasst werden können. Vorzugsweise werden Daten von dem Prüfgerät 17 nur dann gespeichert oder zum Lesegerät 2 übertragen, wenn sich Messwerte geändert haben. Dies führt zu einer deutlichen Komprimierung der im Speicher 11 abzulegenden oder zu übertragenden Daten.

Eine andere Möglichkeit der Komprimierung besteht darin, dass innerhalb eines größeren Zeitraumes Minimal- und Maximalwerte detektiert werden und nur die Minimal- und Maximalwerte gespeichert beziehungsweise übertragen werden. Natürlich ist die Übermittlung und Übertragung von Minimal- und Maximalwerten auch zusätzlich zu den normalen Messwerten möglich.

Wie eingangs genannt, sollen solche Parameter in einer RFID-Umgebung gemessen werden, die für einen fehlerfreien Systembetrieb des Systems relevant sind. Hierbei ist insbesondere die Signalstärke zu nennen, aber auch die Datenübertragung zwischen dem Lesegerät 2 und einem im Lesefeld 3 befindlichen Datenträger 4 kann Aufschlüsse über den Zustand des RFID-Systems geben.

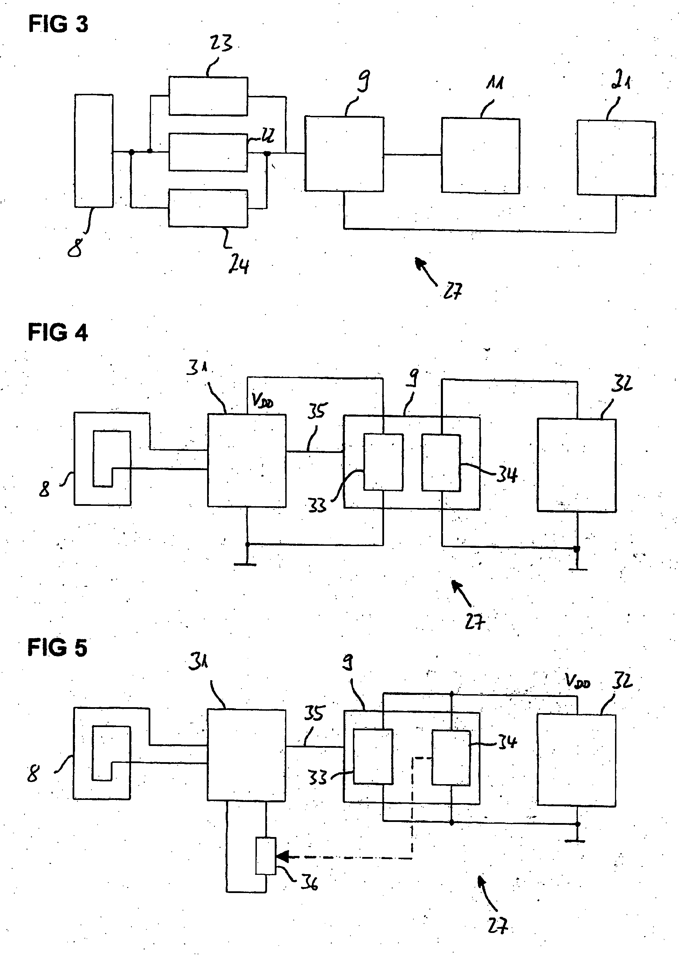

Die Figur 3 zeigt einen schematischen Aufbau eines Prüfgerätes 27, welches zur Erfassung der Signalstärke sowie zum Mitlesen einer Datenübertragung geeignet ist. Zudem kann dieses Prüfgerät 27 in einem Emulationsmodus betrieben werden, in dem es einen Datenträger im Feld emuliert.

Der grundsätzliche Aufbau entspricht einer Kombination der Prüfgeräte 7 von Figur 1 und 17 von Figur 2. Eine Kommunikationsschnittstelle 21 ist zur leitungsgebundenen Übertragung von Messergebnissen zum Lesegerät 2 eingerichtet. Es handelt sich um eine bidirektionale Schnittstelle, über die zudem Steuerbefehle und Konfigurationsdaten von dem Lesegerät empfangen werden können. Die Kommunikationsschnittstelle 21 ist mit der Steuereinrichtung 9 verbunden. Die Steuereinrichtung 9 ist außerdem mit einem Speicher 11 verbunden, in dem Messergebnisse zwischengespeichert werden können. Außerdem können in dem Speicher 11 Konfigurationsdaten abgelegt werden, die den Prüfablauf festlegen beziehungsweise beeinflussen. Zur Erfassung von Messwerten ist eine Antenne 8 vorgesehen, beispielsweise eine Dipolantenne für die Durchführung von Messungen im 867 MHz bzw. UHF Bereich. Um die Stärke des Lesefelds 3 messen zu können, ist ein Signalstärkedetektor 22 vorgesehen, der einerseits mit der Antenne 8 und andererseits mit der Steuereinrichtung 9 verbunden ist. Um Daten, die zwischen dem Lesegerät 2 und einem Datenträger übertragen werden, mitzulesen, ist ein Demodulator 23 vorgesehen. Diese extrahiert den Datenstrom aus dem gemessenen Feldsignal. Um einen Datenträger emulieren zu können, ist darüber hinaus ein Modulator 24 vorgesehen, der von der Steuereinrichtung 9 angesteuert werden kann, um bestimmte Daten zu senden.

Über den Signalstärkedetektor 22 kann die Stärke des Lesefeldes 3 gemessen werden, außerdem ist feststellbar, ob ein Datenträger sich im Lesefeld 3 befindet. Die Fähigkeit, die Datenübertragung zwischen dem Lesegerät 2 und dem Datenträger 4 mitlesen zu können, gibt die Möglichkeit, aus diesem Datenverkehr Rückschlüsse auf den Zustand des RFID-Systems zu ziehen. Denn die zeitlichen Abstände von Befehlen innerhalb einer Befehlsfolge lassen beispielsweise erkennen, ob die Kommunikation zwischen einem Lesegerät 2 und einem Datenträger 4 problemlos erfolgt, oder ob die Leserate schlecht ist. Dies wäre normal, wenn viele Datenträger im Feld sind und gleichzeitig mit dem Lesegerät 2 kommunizieren. Wenn aber nur ein Datenträger 4 im Feld ist und das Lesefeld 3 normale Feldstärke aufweist, lässt eine schlechte Leserate auf einen anderen Fehler schließen. Dieser führt zwar noch nicht zum Ausfall des RFID-Systems, es könnte aber zu einer weiteren Verschlechterung kommen, so dass das Ergreifen von Gegenmaßnahmen bereits jetzt sinnvoll ist. Das Prüfgerät 27 gibt in diesem Fall eine dementsprechende Fehlermeldung an das Lesegerät 2 aus, wobei dieses eine Benutzerschnittstelle aufweisen kann um den Fehler einem Benutzer anzuzeigen.

In einem Emulationsmodus hat das Prüfgerät 27 die Aufgabe, einen Datenträger im Feld zu emulieren. Er kommuniziert über die Antenne 8 also mit dem Lesegerät 2 wie ein normaler passiver Datenträger. Allerdings besitzt das Prüfgerät 27, wie unten anhand der Figuren 4 und 5 erläutert wird, eine aktive Energieversorgung, um eine höhere Empfindlichkeit zu ermöglichen. Bezüglich der Kommunikation vom Lesegerät zum Datenträger als auch in der Kommunikation vom Datenträger zum Lesegerät werden die Kommunikationsprinzipen passiver Datenträger verwendet. Im Speziellen seien hierfür die Begriffe "Passive Backscatter" und "Lastmodulation" erwähnt. In einem einfachen Fall gibt der Datenträger nur eine Identifikationsnummer (ID) zurück, wenn ein Lesefeld 3 erkannt wird. Die vom Prüfgerät 27 gesendete ID ist eine reservierte Nummer, so dass es auf Seiten des Lesegerätes nicht zu Irritationen bzw. Verwechslung mit einem normalen Datenträger 4 kommen kann. Die ID kann auch zuvor zwischen dem Lesegerät 2 und dem Prüfgerät 27 vereinbart worden sein.

Es können aber auch komplexere Datenträger emuliert werden. In Abhängigkeit der vom Demodulator erkannten Signale und vorhandener Konfigurationseinstellungen wird eine Antwort an das Lesegerät 2 gesendet. Die Modulation kann dabei erfindungsgemäß bewusst fehlerhaft erfolgen, um Defekte oder außerhalb des zulässigen Toleranzbereichs liegende Datenträger zu emulieren. Die Modulation kann in Abhängigkeit von der gemessenen Signalstärke variiert werden oder sogar ganz ausgesetzt werden. Dabei kann beispielsweise der zeitliche Signalverlauf, die Signalamplitude oder die Phasenlage verändert werden. Die Änderungen können sich innerhalb oder außerhalb einer Spezifikation bewegen, je nachdem welche Betriebsbedingung simuliert werden soll.

Zeitinformation, welche, wie bereits oben beschrieben, mit den Messergebnissen gespeichert werden können, beinhalten entweder eine relative Zeitinformation, beispielsweise die zeitliche Abfolge innerhalb einer Befehlsfolge, oder aber es wird eine Echtzeitinformation aus einer Uhr erfasst und mit abgespeichert.

Es ist auch möglich, mit dem Prüfgerät 27 die Daten zu erfassen, die von einem anderen Datenträger an das Lesegerät 2 zurückgesendet werden. Diese Signale sind jedoch sehr schwach, so dass mit einer für die Messung von Feldstärken oder Daten vom Lesegerät eigentlich ausreichende Antenne keine ausreichende sichere Erkennung gewährleistet werden kann. In Anwendungsfällen, in den dies wichtig ist, könnte aber eine leistungsfähigere Antenne 8 eingesetzt werden, die auch schwache Signale anderer Datenträger zuverlässig erfasst.

Für das Prüfgerät 27 kann eine Hardware verwendet werden, wie sie auch für Datenträger eingesetzt wird. Der Speicher 11 solcher Datenträger ist jedoch in der Regel verhältnismäßig klein, so dass über einen längeren Zeitraum erfasste Messergebnisse nicht alle abgespeichert werden können. In einem weitergebildeten Ausführungsbeispiel wird deswegen die freie Kapazität des Speichers 11 ermittelt und je nach Ergebnis nur noch komprimierte Daten abgespeichert. Andererseits ist es möglich, bei Erkennen von Speicherplatzproblemen auch die bereits vorhandenen Daten nachträglich zu komprimieren.

Das Prüfgerät kann so erweitert werden, so dass es für Fernwartung geeignet ist. In Abhängigkeit von erkannten Fehlern werden automatisch oder gesteuert über die Kommunikationsschnittstelle 21 Maßnahmen zur "Reparatur" des RFID-Systems durchgeführt. Hier ist durch die Anbindung ans Firmennetzwert (Intranet) oder ans Internet die Möglichkeit gegeben, dass eine zentrale Überwachungsgruppe alle RFID Systemdaten analysiert und automatisch Repartur oder Wartungsaufträge startet. Im Falle der Anbindung über das Internet können solche Aktivitäten von RFID Experten durchgeführt werden ohne das eben solche Vorort oder im gesamten Betrieb sein müssen.

In einer weiter verbesserten Ausführung eines Prüfgeräts kann dieses mehrere Datenträger emulieren, wobei es dazu eine oder mehrere Antennen aufweist. Komplexe Prüfprogramme können mit Sensoren für Umwelteinflüsse zusammenarbeiten, so dass diese, beispielsweise Störsignale auf anderen Frequenzen oder auch Einflüsse wie Temperatur, bei der Bewertung der Funktionsfähigkeit des RFID-Systems berücksichtigt werden. In komplexen Systemen kann es sinnvoll sein, mehrere Prüfgeräte einzusetzen, welcher an unterschiedlichen Stellen die Fehlerfreiheit des Systems überwachen.

In der Figur 4 sind die Energieversorgungskomponenten sowie die Komponenten gezeigt, welche zur Emulation des passiven Datenträgers in Bezug auf die Rückwirkungen auf das Lesefeld vorgesehen sind.

Die Antenne 8 ist mit einer Schnittstellenvorrichtung 31 verbunden, welche auch den Demodulator 23, den Signalstärkedetektor 22 und den Modulator 24 enthalten kann. Zudem bildet die Schnittstellenvorrichtung 31 eine Stromversorgungseinheit, indem aus der Feldenergie des Lesefeldes eine Versorgungsspannung erzeugt wird, wie dies bei passiven Datenträgern der Fall ist. Die hierzu vorgesehenen elektrischen Komponenten beeinflussen natürlich auch die Demodulation, so dass durch diese Komponenten das Verhalten des Prüfgerät im Emulationsmodus im Hinblick auf eine möglichst gute Emulation verbessert wird.

Eine weitere Verbesserung kann erzielt werden, wenn die Stromversorgungseinheit 31 belastet wird. Dazu ist sie im Ausführungsbeispiel von Figur 4 mit Funktionseinheiten 33 des Prüfgeräts 27 verbunden, die im gezeigten Beispiel Teile der Steuereinrichtung 9 sind. Es kann sich um einen Chip handeln, wie er normalerweise bei passiven Datenträgern eingesetzt wird. Eine Vorsorgung sämtlicher Komponenten des Prüfgerät wäre je nach Anwendungsfall möglich, im Interesse einer möglichst guten Emulation aber nachteilig, weil der Strombedarf im Vergleich zu einem passiven Datenträger zu groß wäre. Die Stromversorgung der übrigen Komponenten des Prüfgeräts 27 erfolgt über eine von dem Lesefeld unabhängige Energieversorgungseinheit 32. Diese besitzt entweder einen Energiespeicher wie einen Akku oder wird von extern mit Strom versorgt. Dies kann über ein Netzteil oder z.B. auch über eine leitungsgebundene Kommunikationsschnittstelle erfolgen.

Bei dem Ausführungsbeispiel von Figur 5 ist eine zusätzliche Last 36 vorgesehen, durch die die Stromversorgungseinheit belastet wird. Es kann sich um eine konstante Last wie einen Widerstand handeln, oder um eine steuerbare Last wie einen Transistor oder eine Kapazitätsdiode. Es können auch.eine oder mehrere schaltbare Lasten eingesetzt werden wie Widerstände, Kapazitäten oder Induktivitäten. Dadurch kann die Last zusätzlich dadurch variiert werden, dass einzelne Lastkomponenten zu- oder abgeschaltet bzw. kurzgeschlossen werden. So kann beispielsweise in einfacher Weise die Phasenlage des Datensignals beeinflusst werden.

Eine steuerbare Last hat den Vorteil, dass besondere Lastprofile nachgebildet werden können, zum Beispiel Belastungspeaks oder verschiedene Amplituden oder Phasenlagen, die typischerweise Schwierigkeiten bei der Demodulation oder Modulation bereiten. Die Last wird in diesem Fall von Komponenten 24 der Steuereinrichtung 9 angesteuert. Die Stromversorgung der Steuereinrichtung erfolgt über die von dem Lesefeld unabhängige Energieversorgungseinheit 32.

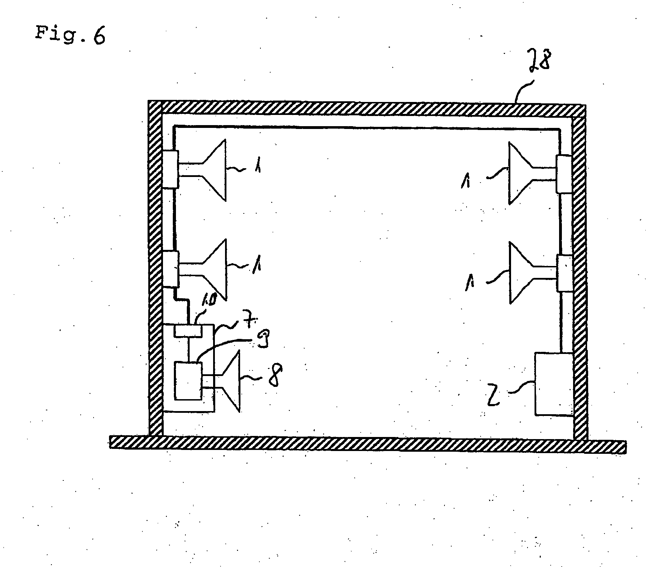

Figur 6 zeigt ein weiteres Ausführungsbeispiel einer erfindungsgemäßen RFID-Anordnung in einer schematischen Darstellung. Ein Lesegerät 2 ist mit mehreren Antennen 1 gekoppelt, um in einem Durchgang 28, beispielsweise einer Tür, ein Lesefeld zu erzeugen. Außerdem ist ein Prüfgerät 7 angeschlossen, welches zur Messung des Lesefeldes eingerichtet ist. Insbesondere in solchen komplexeren Anordnungen ist die Integration eines Prüfgerätes in das RFID-System sinnvoll. Wenn beispielsweise bei der Antenne links oben eine Störung auftritt, findet in vielen Fällen eine korrekte Übertragung zwischen einem Datenträger und dem Lesegerät 2 statt, aber nur, wenn der Datenträger in der Nähe einer der anderen drei Antennen ist. Wenn sich jedoch ein Datenträger im linken oberen Bereich des Durchgangs 28 befindet, kommt es zu einem Fehler, was zunächst als sporadisch auftretender Fehler erscheint. Über das Prüfgerät 7 kann jedoch schon aufgrund des gemessenen Feldes festgestellt werden, dass nicht alle Antennen ordnungsgemäß funktionieren. Durch Beobachten des Datenverkehrs zwischen dem Lesegerät und Datenträgern, die sich im Feld befinden, kann zudem festgestellt werden, dass die Datenkommunikation zwischen drei der Antennen und einem Datenträger problemlos funktioniert, während die vierte Antenne keine korrekte Kommunikation mit einem Datenträger vornimmt. Die Fehlererkennung ist nicht davon abhängig, ob eine Datenträger letztlich erkannt wird oder nicht, da bereits die Kommunikation zwischen dem Lesegerät 2 und dem Datenträger über die betreffende Antenne ausgewertet wird.

Insbesondere beim Totalausfall einer Antenne ist von Vorteil, wenn das Prüfgerät 7 die Signalstärke auswertet. Denn dabei stellt das Prüfgerät 7 aufgrund der Feldstärkenänderung des Lesefeldes fest, dass sich ein Datenträger im Lesefeld befindet. Wenn keine der Antennen eine Kommunikation mit den Datenträgern aufnimmt, muss es sich also um einen Fehler bei einer der Antennen handeln, Was durch eine Warnmeldung an das Lesegerät 2 mitgeteilt werden kann.

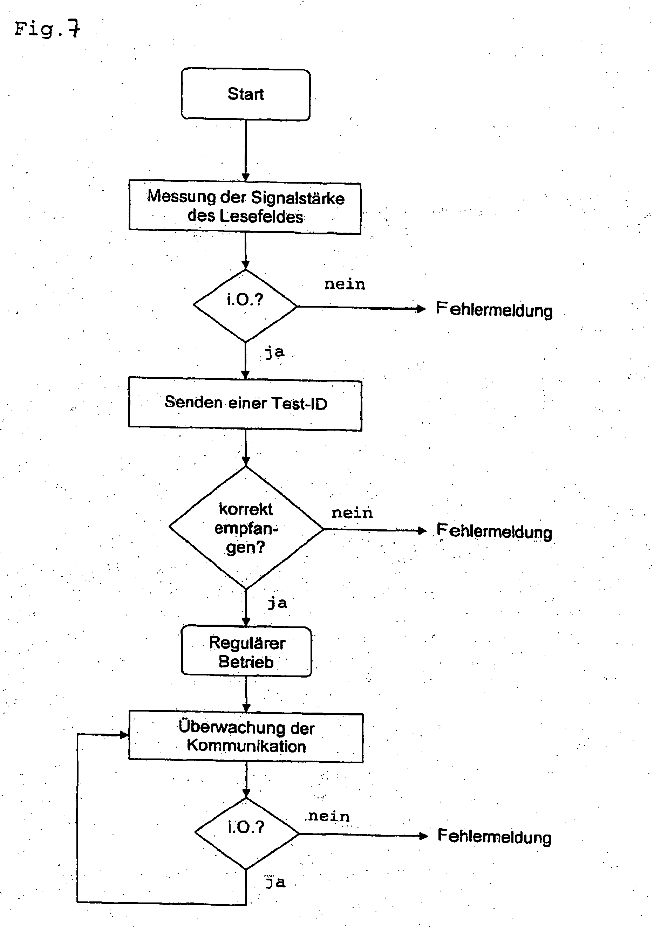

Der Ablauf beim Betrieb eines RFID-Systems, wie es in den Ausführungsbeispielen beschrieben wurde, erfolgt beispielsweise wie in Figur 7 dargestellt ist. Nach dem Start des RFID-Systems wird zunächst die Signalstärke des Lesefeldes gemessen. Ist dies in Ordnung, kann daraus geschlossen werden, dass die Antennen ordnungsgemäß funktionieren. Andernfalls wird eine Fehlermeldung ausgegeben. Anschließend wird vom Prüfgerät 7 eine Test-ID gesendet. Wenn diese von dem Lesegerät 2 korrekt erkannt wird, so steht fest, dass auch das Lesegerät in ordnungsgemäßem Zustand ist. Andernfalls wird eine Fehlermeldung ausgegeben. Nach diesem zweiten Prüfschritt beginnt der reguläre Betrieb des RFID-Systems. Im regulären Betrieb erfolgt eine fortlaufende Überwachung der Kommunikation zwischen dem Lesegerät 2 und den im Lesegerät 3 befindlichen Datenträgern 4. Werden dabei Fehler festgestellt, kommt es zu einer Fehlermeldung. Anderenfalls wird die Überwachung fortgesetzt, so lange der reguläre Betrieb des RFID-Systems andauert.

Weitere Ausführungsbeispiele der erfindungsgemäßen Anordnung oder des beschriebenen Verfahrens liegen im Ermessen des Fachmannes und sind von der Erfindung umfasst.

### Bezugszeichenliste

- 1: Antenne
- 2: Lesegerät
- 3: Lesefeld
- 4: Datenträger
- 5: Chip
- 6: Antenne
- 7: Prüfgerät
- 8: Antenne
- 9: Steuereinrichtung
- 10: Schnittstelle
- 11: Speicher
- 17: Prüfgerät
- 20: Schnittstelle
- 21: Schnittstelle
- 22: Signalstärkedetektor
- 23: Demodulator
- 24: Modulator
- 27: Prüfgerät
- 28: Durchgang
- 31: Schnittstellenvorrichtung
- 32: Energieversorgungseinheit
- 33: erste Funktionskomponenten
- 34: zweite Funktionskomponenten
- 35: Datenleitung
- 36: Last

- VDD: Versorgungsspannung

## Patentansprüche

1. Prüfgerät für RFID-Systeme, aufweisend
- eine Antenne (8),
- eine Steuereinrichtung (9) und
- eine Kommunikationsschnittstelle (10; 20; 21) und
- eine von dem Lesefeld eines Lesegeräts unabhängige Energieversorgungseinheit (32)
wobei das Prüfgerät (7; 17; 27) dazu eingerichtet ist, Lesefelder (3) von Lesegeräten (2) des RFID-Systems mittels der Antenne (8) zu messen und Messergebnisse über die Kommunikationsschnittstelle (10; 20; 21) bereitzustellen,
- eine Vorrichtung (33; 36) zur Belastung des Lesefelds des Lesegeräts über die Antenne (8) zur Emulation eines passiven Datenträgers durch Nachbildung der Rückwirkung eines passiven Datenträgers auf das Lesefeld, **dadurch gekennzeichnet, daß** das Prüfgerät dazu eingerichtet ist, in einem Emulationsmodus das Verhalten eines passiven Datenträgers (4) im Lesefeld eines Lesegerätes (2) durch Veränderung der Belastung des Lesefeldes zu emulieren und in dem Emulationsmodus eine Modulation durch Veränderung der Belastung des Lesefeldes fehlerhaft durchzuführen, um Defekte oder außerhalb des Toleranzbereichs liegende Datenträger zu emulieren.

2. Prüfgerät nach Anspruch 1,
**dadurch gekennzeichnet, dass** als Vorrichtung zur Belastung des Feldes des Lesegeräts eine Stromversorgungseinheit (31) vorgesehen ist, die Energie des Lesefeld in eine Versorgungsspannung (VDD) umwandelt.

3. Prüfgerät nach Anspruch 2,
**dadurch gekennzeichnet, dass** an die Stromversorgungseinheit (31) als Last elektronische Funktionseinheiten (33) des Prüfgeräts (27) angeschlossen sind.

4. Prüfgerät nach Anspruch 2,
**dadurch gekennzeichnet, dass** an die Stromversorgungseinheit (31) als Last ein Widerstand (36) oder eine steuerbare Last angeschlossen ist.

5. Prüfgerät nach einem der Ansprüche 1 bis 4,
**gekennzeichnet durch** einen Signalstärkedetektor (22) zur Messung der von einem Lesegerät (2) erzeugten Feldstärke.

6. Prüfgerät nach Anspruch 5,
**dadurch gekennzeichnet, dass** es dazu eingerichtet ist festzustellen, welche von mehreren Antennen eines Lesegerätes (2) zur Felderzeugung aktiv ist.

7. Prüfgerät nach einem der Ansprüche 1 bis 6,
**gekennzeichnet durch** einen Demodulator (23) zur Demodulation eines gemessenen Signals, wobei der Demodulator (23) zur Weiterverarbeitung der so erhaltenen Daten mit der Steuereinrichtung (9) verbunden ist, wobei es dazu eingerichtet ist, Befehlsfolgen aufzuzeichnen, die von einem Lesegerät (2) an einen Datenträger gesendet (4) werden.

8. Prüfgerät nach einem der Ansprüche 1 bis 7,
**dadurch gekennzeichnet, dass** es dazu eingerichtet ist, die Modulation in Abhängigkeit von einer gemessenen Signalstärke zu variieren oder auszusetzen.

9. Prüfgerät nach einem der Ansprüche 1 bis 8,
**dadurch gekennzeichnet, dass** über eine oder mehrere Antennen das Verhalten mehrerer Datenträger (4) im Lesefeld (3) eines Lesegerätes (2) emuliert wird.

10. Verfahren zum Betreiben eines Prüfgeräts nach einem der vorhergehenden Ansprüche in einem RFID-System mit den Schritten:
a) Start des RFID-Systems
b) Messung der Signalstärke des Lesefeldes eines Lesegeräts,
c) Überprüfung, ob in dem Schritt b) eine Unregelmäßigkeit aufgetreten ist, wenn ja Ausgabe einer Warnmeldung,
d) Fortlaufende Überwachung der Kommunikation zwischen dem Lesegerät und im Lesefeld befindlichen Datenträgern,
e) Überprüfung, ob im Schritt d) eine Unregelmäßigkeit aufgetreten ist, wenn ja Ausgabe einer Warnmeldung.

11. Verfahren nach Anspruch 10,
**dadurch gekennzeichnet, dass** die Überprüfung im Schritt e) durch das Lesegerät ausgeführt wird.

12. Verfahren nach einem der Ansprüche 10 oder 11,
**dadurch gekennzeichnet, dass** als weitere Prüfmaßnahme eine Test-Nachricht an das Lesegerät gesendet und nachfolgend überprüft wird, ob die Nachricht ohne Unregelmäßigkeiten empfangen wurde.

13. Verfahren nach Anspruch 12,
**dadurch gekennzeichnet, dass** das Lesegerät eine Erkennung der Test-Nachricht dem Prüfgerät mitteilt und dieses anschließend eine Überwachung und Überprüfung gemäß den Schritten d) und e) durchführt.

14. Verfahren nach einem der Ansprüche 10 bis 13,
**dadurch gekennzeichnet, dass** aus der Messung von Signälstärken und der Überwachung von Kommunikation erhaltene Daten an eine Auswerteeinheit außerhalb des Prüfgeräts übermittelt werden.

## Claims

1. Tester for RFID systems, having
- an antenna (8),
- a control device (9) and
- a communication interface (10; 20; 21) and
- a power supply unit (32) that is independent of the reader field of a reader,
wherein the tester (7; 17; 27) is set up to measure reader fields (3) of readers (2) of the RFID system using the antenna (8) and to provide measurement results via the communication interface (10; 20; 21),
- an apparatus (33; 36) for applying a load to the reader field of the reader via the antenna (8) in order to emulate a passive data carrier by reproducing the effect of a passive data carrier on the reader field, **characterized in that** the tester is set up to emulate the behaviour of a passive data carrier (4) in the reader field of a reader (2) in an emulation mode by altering the load applied to the reader field and to perform modulation in the emulation mode by altering the load applied to of the reader field erroneously in order to emulate faults or data carrier operating outside the tolerance range.

2. Tester according to Claim 1,
**characterized in that** the apparatus provided for applying a load to the field of the reader is a power supply unit (31) that converts energy of the reader field into a supply voltage (VDD).

3. Tester according to Claim 2,
**characterized in that** the power supply unit (31) has electronic functional units (33) of the tester (27) connected to it as a load.

4. Tester according to Claim 2,
**characterized in that** the power supply unit (31) has a resistor (36) or a controllable load connected to it as a load.

5. Tester according to one of Claims 1 to 4,
**characterized by** a signal strength detector (22) for measuring the field strength produced by a reader (2).

6. Tester according to Claim 5,
**characterized in that** it is set up to determine which of a plurality of antennas of a reader (2) is active for field generation.

7. Tester according to one of Claims 1 to 6,
**characterized by** a demodulator (23) for demodulating a measured signal, wherein the demodulator (23) is connected to the control device (9) for the purpose of processing the data obtained in this manner further, wherein said tester is set up to record command sequences that are sent (4) to a data carrier by a reader (2).

8. Tester according to one of Claims 1 to 7
**characterized in that** it is set up to vary or suspend the modulation on the basis of the measured signal strength.

9. Tester according to one of Claims 1 to 8,
**characterized in that** one or more antennas are used to emulate the behaviour of a plurality of data carrier (4) in the reader field (3) of a reader (2).

10. Method for operating a tester according to one of the preceding claims in an RFID system having the steps of:
a) starting the RFID system,
b) measuring the signal strength of the reader field of a reader,
c) checking whether an irregularity has occurred in step b), and outputting a warning signal if so,
d) continually monitoring the communication between the reader and data carriers situated in the reader field,
e) checking whether an irregularity has occurred in step d), and outputting a warning signal if so.

11. Method according to Claim 10,
**characterized in that** the check in step e) is carried out by the reader.

12. Method according to either of Claims 10 and 11,
**characterized in that** as a further checking measure a test message is sent to the reader and a check is subsequently performed to determine whether the message has been received without irregularities.

13. Method according to Claim 12,
**characterized in that** the reader communicates recognition of the test message to the tester and the latter then performs monitoring and checking according to steps d) and e).

14. Method according to one of Claims 10 to 13, **characterized in that** data obtained from the measurement of signal strengths and the monitoring of communication are transmitted to an evaluation unit outside the tester.

## Revendications

1. Appareil de vérification pour systèmes RFID, présentant :
une antenne (8),
un dispositif de commande (9),
une interface de communication (10; 20; 21) et
une unité (32) d'alimentation en énergie indépendante du champ de lecture d'un appareil de lecture,
l'appareil de vérification (7; 17; 27) étant conçu pour mesurer des champs de lecture (3) d'appareils de lecture (2) du système RFID au moyen de l'antenne (8) et de délivrer les résultats de mesure par l'intermédiaire de l'interface de communication (10; 20; 21),
un dispositif (33; 36) de chargement du champ de lecture de l'appareil de lecture par l'intermédiaire de l'antenne (8) en vue d'émuler un support de données passif par imitation de la rétroaction d'un support de données passif sur le champ de lecture,
**caractérisé en ce que**
l'appareil de vérification est conçu pour, en mode d'émulation, émuler le comportement d'un support de données (4) passif dans le champ de lecture d'un appareil de lecture (2), par modification de la charge du champ de lecture et, en mode d'émulation, d'exécuter de manière erronée une modulation par modification de la charge du champ de lecture pour émuler des défauts ou des supports de données situés à l'extérieur de la plage de tolérances.

2. Appareil de vérification selon la revendication 1, **caractérisé en ce qu'**une unité (31) d'alimentation en courant qui convertit l'énergie du champ de lecture en une tension d'alimentation (VDD) est prévue comme dispositif de charge du champ de l'appareil de lecture.

3. Appareil de vérification selon la revendication 2, **caractérisé en ce que** des unités fonctionnelles électroniques (33) de l'appareil de vérification (27) sont raccordées en tant que charges à l'unité (31) d'alimentation en courant.

4. Appareil de vérification selon la revendication 2, **caractérisé en ce qu'**une résistance (36) ou une charge asservie sont raccordées en tant que charges à l'unité (31) d'alimentation en courant.

5. Appareil de vérification selon l'une des revendications 1 à 4, **caractérisé par** un détecteur (22) d'intensité de signaux qui mesure les intensités des champs formés par un appareil de lecture (2).

6. Appareil de vérification selon la revendication 5, **caractérisé en ce qu'**il est conçu pour vérifier la quelle des différentes antennes d'un appareil de lecture (2) est active en création de champ.

7. Appareil de vérification selon l'une des revendications 1 à 6, **caractérisé par** un démodulateur (23) qui démodule un signal mesuré, le démodulateur (23) étant raccordé au dispositif de commande (9) de manière à poursuivre le traitement des données ainsi obtenues et étant conçu pour distinguer des successions d'ordres qui sont envoyés (4) par un appareil de lecture (2) à un support de données.

8. Appareil de vérification selon l'une des revendications 1 à 7, **caractérisé en ce qu'**il est conçu pour modifier ou interrompre la modulation en fonction de l'intensité mesurée d'un signal.

9. Appareil de vérification selon l'une des revendications 1 à 8, **caractérisé en ce que** le comportement de plusieurs supports de données (4) dans le champ de lecture (3) d'un appareil de lecture (2) est émulé par l'intermédiaire d'une ou plusieurs antennes.

10. Procédé de conduite d'un appareil de vérification selon l'une des revendications précédentes dans un système RFID, le procédé présentant les étapes qui consistent à :
a) démarrer le système RFID,
b) mesurer l'intensité du signal du champ de lecture d'un appareil de lecture,
c) vérifier si à l'étape b) une irrégularité est survenue et si oui, délivrer un message d'alarme,
d) surveiller en permanence la communication entre l'appareil de lecture et les supports de données présents dans le champ de lecture et
e) vérifier si à l'étape d) une irrégularité est survenue et si oui, délivrer un message d'alarme.

11. Procédé selon la revendication 10, **caractérisé en ce que** la vérification à l'étape e) est exécutée par l'appareil de lecture.

12. Procédé selon l'une des revendications 10 ou 11, **caractérisé en ce que** comme autre disposition de vérification, un message de test est envoyé à l'appareil de lecture, avec ensuite vérification si le message a été reçu sans irrégularité.

13. Procédé selon la revendication 12, **caractérisé en ce que** l'appareil de lecture communique à l'appareil de vérification la reconnaissance d'un message de test et **en ce que** ce dernier exécute ensuite une surveillance et une vérification à l'aide des étapes d) et e).

14. Procédé selon l'une des revendications 10 à 13, **caractérisé en ce qu'**à partir de la mesure de l'intensité de signaux et de la surveillance de la communication, les données obtenues sont transmises à une unité d'évaluation située à l'extérieur de l'appareil de vérification.
